# EUROPEAN PATENT APPLICATION

(11) **EP 1 912 487 A1**
(43) Date of publication of application: **16.04.2008**
(21) Application number: 06714884.1
(22) Date of filing: 28.02.2006
(51) Int. Cl.: H05K 9/00, H01Q 17/00

(54) **ELECTROMAGNETIC WAVE ABSORBER**

(30) Priority: 29.07.2005 JP 2005221453
(71) Applicant: Bussan Nanotech Research Institute Inc., Tokyo 100-0004 (JP)
(72) Inventor: UMISHITA, Kazunori, Tokyo 100-0004 (JP); ENDO, Morinobu, Nagano 380-8553 (JP); OKUBO, Tsuyoshi, Tokyo 100-0004 (JP)
(74) Representative: Brochard, Pascale
(86) International application number: PCT/JP2006/303754
(87) International publication number: WO 2007/013199

(57) **Abstract**

The disclosed is an electromagnetic wave absorber which is **characterized in that** ultrathin carbon fibers which show a negative magneto-resistance are contained in the matrix, at a ratio of 0.01 - 20 % by weight based on the total weight. By using a loss material which shows a high electromagnetic waves absorption capability at a small amount, the electromagnetic wave absorber which demonstrates a strong electromagnetic radiation absorption capability without deteriorating the characteristics of the matrix. In addition, this electromagnetic wave absorber has a good formability while being made of a low cost composite material, and is useful as electromagnetic wave absorber for GHz band.

## Description

### TECHNICAL FIELD

This invention relates to an electromagnetic wave absorber, especially, to an electromagnetic wave absorber for gigahertz (GHz) band.

### BACKGROUND ART

Recently, high-speed processing of electronic devices has been accelerated, and the operating frequencies for ICs such as LSIs or microprocessors have been ascended rapidly. Thus, there are increasing tendencies to emit unnecessary noises. In addition, in the field of communications, 2 GHz has been utilized for the next generation multimedia mobile communication, 2 - 30 GHz for wireless LAN, and high-speed communication network using optical fibers, as well as 5.8 GHz for ETS (Electronic Toll Collection System) and 76GHz for AHS (advanced cruise-assist highway system) in the field of ITS(Intelligent Transport System), etc. Further, the range of using the high frequency such as GHz band is expected to be going to expand rapidly in the future.

By the way, when the frequency of the electromagnetic waves rise, the misoperations of electronic devices due to EMI (Electro-Magnetic Interference) will arise because of the degression in the noise margin due to the energy - saving of the recent electronic devices, and the deterioration of the environment of the noise in the electronic devices due to the tendency of miniaturizing and densification of electronic devices, while the electromagnetic waves becomes easy to be radiated as noise. Thus, in order to decrease EMI in an electronic device, measures such as the arrangement of the electromagnetic wave absorber in the electronic device have been taken. Conventionally, as the electromagnetic wave absorber for GHz band, a seat-like article which is made by combining an electrical insulating organic material such as rubber or resin with a soft magnetic metallic material having spinel crystal structure and a loss material such as carbon material is mainly utilized.

However, the relative permeability of the soft magnetic metallic oxide material having spinel crystal structure decreases abruptly at the GHz band according to Snoek's law of threshold. Therefore, the threshold frequency of the material as the electromagnetic wave absorber is a few several GHz. With respect to the soft magnetic metallic material, although it is possible to extend the threshold frequency of the material as the electromagnetic wave absorber up to about 10 GHz owing to the repression effect against the eddy currents and the effect of magnetic shape anisotropy which are obtained by forming particles into flatten shapes of not more than the skin depth, however, such a magnetic material has a heavy weight, and thus, it is impossible to achieve a light weight electromagnetic wave absorber.

On the other hand, as the electromagnetic wave absorber for millimeter wave range, an electromagnetic wave absorber in which carbonaceous material such as carbon black particles or carbon fibers is dispersed in an electrical insulating organic material such as rubber or resin is known in the art. However, its electromagnetic wave absorption capability does not reach a sufficient level, and thus, the development of an electromagnetic wave absorber excellent in the electromagnetic wave absorption capability which can be used even for the millimeter wave range has been sought.

In addition, in the patent literature 1, an electromagnetic wave absorber which contains electro conductive carbon nanotubes has been disclosed, and it has been reported that the attenuation rates of -13 dB(5GHz, 0.105mm in thickness) and -23dB (5GHz, 0.105mm in thickness) were obtained. In the patent literature 2, carbon nanotube which bore or involved alkaline, alkaline earth metal, rare earth, or VIII group's metal has been disclosed, and it has been reported that the attenuation rates of -28 dB (16GHz, 1mm in thickness), -34dB (10GHz, 1.5mm in thickness), and -27dB (7GHz, 2mm in thickness) were obtained in a composite in which 20 parts by weight of Fe involved carbon nanotubes were contained in polyester or the like. In the patent literature 3, a polymer composite which contained 20 parts by weight of carbon nanotubes having a diameter of 1 - 100 nm and a length of not more than 50 µm has been disclosed, and it has been reported that the attenuation rates of -37 dB (9.5 GHz, 1mm in thickness), -27 dB (2.7 GHz, 0.8mm in thickness), and -30 dB (2.1GHz, 0.8mm in thickness) were obtained. In the patent literature 4, it has been reported that the attenuation rates of 20-29 dB were obtained by a stacked structure of fibrous carbon or nano carbon. In the patent literature 5, an electromagnetic wave absorber obtained by placing carbon material including fibrous carbon and nano carbon tubes between resin coated papers, and heating and pressurizing them has been disclosed, and it has been reported that it could absorb the electromagnetic wave of 60GHz by 20-35 dB when the thickness of its conductive layer was 9mm.

Since the electromagnetic wave absorber described in the patent literature 1 is prepared by admixing graphite and resin in nearly equal proportions, it can hardly sustain the mechanical characteristics, such as toughness, of the resin. Further, the graphite makes the surface roughness rough, and this fact will cause an increase in the exfoliation of surface layer and a decrease in surface conductivity.

The supporting technology disclosed in the patent literature 2 is extremely difficult, and the leaved material to be supported and the leaved carbon nanotubes mutually independently agglomerate, and which is followed by the deterioration of the electromagnetic wave absorption capability. Particularly, the metals are easy to be oxidized because of its minute particle shapes, and thereby the electromagnetic wave absorption capability is degraded. Although such dropping off and oxidation can be solved by involving the material to be supported into the carbon nanotubes, the yield of such involved form is extremely low.

Next, in the patent literature 3, the electromagnetic wave absorption capability was obtained by including a comparatively high density, i.e., 1 - 10 parts by weight of carbon nanotubes, and the physical properties of the matrix, especially mechanical properties are subject to change. Moreover, the attenuation rate is varied greatly depending upon the carbon nanotubes used.

The electromagnetic wave absorber described in the patent literature 4 requires a metallic thin film, such as Ag, Cu, Au or Pt, of about 10 nm in thickness between two layers of carbon nanotube containing layers, and thus the manufacturing process becomes complicated one and costly.

In addition, in the patent literature 5, the electromagnetic wave absorption capability is obtained by shaping a rather large amount of carbonaceous material thickly. Therefore, the formability of the electromagnetic wave absorber is not good, and the usage thereof will be restricted.
Patent literature 1: JP 2005-11878 A
Patent literature 2: JP 2003-124011 A
Patent literature 3: JP 2003-158395 A
Patent literature 4: JP 2005-63994 A
Patent literature 5: JP 2004-327727 A

### DISCLOSURE OF THE INVENTION

### PROBLEMS TO BE SOLVED BY THIS INVENTION

Therefore, in view of the above mentioned problems in the prior arts, the present invention aims to provide a new electromagnetic wave absorber useful for GHz band. The present invention also aims to provide an electromagnetic wave absorber which can demonstrate the electromagnetic wave absorption capability without ruining the characteristic of the matrix, and can enjoy a good formability and a low manufacturing cost by using a high electromagnetic wave absorbing loss material and adding it in a small amount.

### MEANS FOR SOLVING THE PROBLEMS

We, the inventors, have found that the above problems can be solved by using a composite in which relatively small amount of ultrathin carbon fibers which show a negative magneto-resistance is added and dispersed in the matrix, after our diligent studies. Thus, we have attained the present invention.

That is, the electromagnetic wave absorber of the present invention which solves the above mentioned problems is characterized in that ultrathin carbon fibers which show a negative magneto-resistance are contained in the matrix, at a ratio of 0.01 - 20 % by weight based on the total weight.

In the electromagnetic wave absorber according to the present invention, it is preferable that the negative magneto-resistance of the ultrathin carbon fibers is to show negative values in the temperature range of at least not lower than 298K against external magnetic fields of up to 1 Tesla (T).

The present invention also provides the above mentioned electromagnetic wave absorber of which matrix comprises an organic polymer.

Further, the present invention provides the above mentioned electromagnetic wave absorber of which matrix comprises inorganic material.

Still further, the present invention provides the above mentioned electromagnetic wave absorber wherein a filling agent selected from the group consisting of metallic particles, silica, calcium carbonate, magnesium carbonate, carbon blacks, carbon fibers, glass fibers, and blends of two or more of these materials is further added therein.

### EFFECT OF THE INVENTION

Since the ultrathin carbon fibers included into the electromagnetic wave absorber according to the present invention shows a high loss characteristic against the electromagnetic waves of GHz band, the composite which includes such carbon fibers can demonstrate strong electromagnetic radiation absorption regardless of the kind of matrix used. Therefore, the composite can be preferably used as electromagnetic wave absorber for computers, telecommunications equipments, and the electromagnetic wave using device, etc.

### BRIEF DESCRIPTION OF THE DRAWINGS

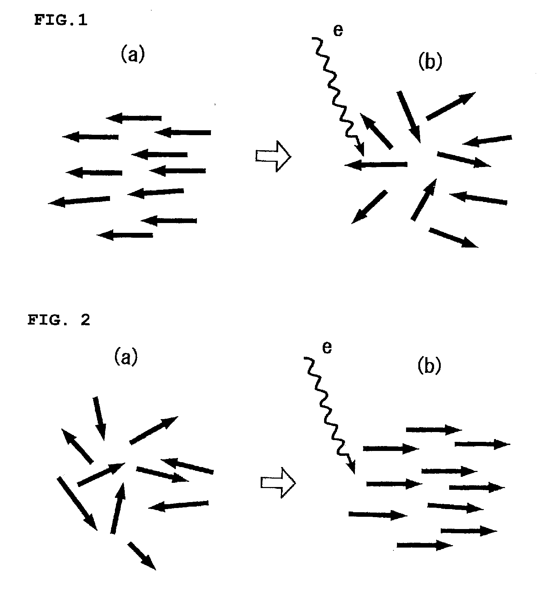

[Fig. 1] is a drawing which illustrates schematically the states of magnetic moments in an infinitesimal region of ultrathin carbon fiber which behaves ferromagnetically, wherein (a) is the normal state, and (b) is the state under irradiation of electromagnetic waves of certain enhanced frequencies.
[Fig. 2] is a drawing which illustrates schematically the states of magnetic moments in an infinitesimal region of ultrathin carbon fiber which shows metallic electro conductivity and is a diamagnetic substance, wherein (a) is the normal state, and (b) is the state under irradiation of electromagnetic waves of certain enhanced frequencies.

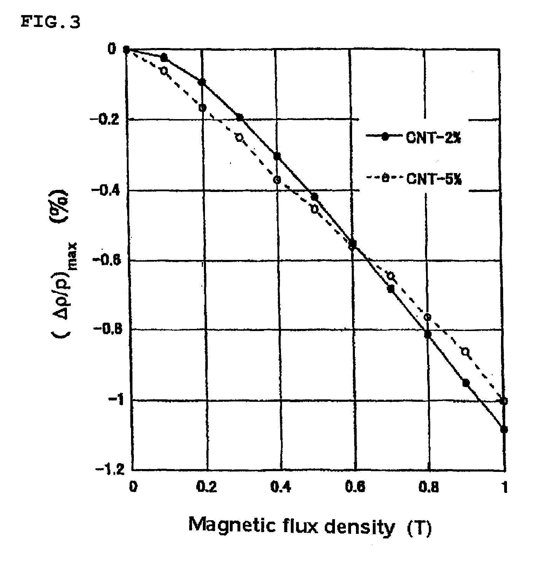

[Fig. 3] is a graph which illustrates the changes in the resistivity of an embodiment of the ultrathin carbon fiber used in the electromagnetic wave absorber according to the present invention under an external magnetic field at 77K.

### BEST MODE FOR CARRYING OUT THE INVENTION

Now, the present invention will be described in detail with reference to some preferable embodiments. Incidentally, the embodiments shown below are introduced herein only for the sake of making the description and understanding of the present invention easy, and thus, the range of present invention is not limited thereto.

The electromagnetic wave absorber according to this invention is characterized in that ultrathin carbon fibers which show a negative magneto-resistance are contained in the matrix, at a ratio of 0.01 - 20 % by weight based on the total weight.

First, the function of the electromagnetic wave absorber according to the present invention will be explained.
In general, the electromagnetic wave absorber is divided roughly into three kinds, that is, the electric resistivity, the dielectric, and the ferromagnetic materials.

With respect to the ultrathin carbon fiber which shows metallic electro conductivity and is a diamagnetic substance, as being differ from the ultrathin carbon fiber used in the present invention, the magnetic moments in it's infinitesimal region take an antiferromagnetically coupled state where the moments are randomly oriented, as shown schematically in Fig. 2(a). When electromagnetic waves e of which frequency is heightened to GHz band region are irradiated to this ultrathin carbon fiber, the magnetic moments do not take the antiferromagnetically (parallely) coupled state, i.e., they take a ferromagnetically coupled state, as shown in Fig. 2 (b) . Thus, the ultrathin carbon fiber does not form an electric resistance equivalent body, and it becomes difficult to absorb high frequency electromagnetic waves, particularly, those of GHz band.

On the other hand, with respect to the ultrathin carbon fiber which behaves ferromagnetically, the magnetic moments in its infinitesimal region take a ferromagnetically coupled state, as shown schematically in Fig. 1 (a) . Under this state, since the electric resistance decreases responding to the application of the external magnetic field of up to a certain magnitude, the magnetic moments can be parallely coupled and easily respond to the changes in the magnetic field due to the electromagnetic wave irradiation without delay. When the frequency of the irradiated electromagnetic waves is heightened, however, it comes to respond to the magnetic field changes with some delays. The parallel couples are disturbed as shown in Fig. 1(b), and the magnetic moments come to take the antiferromagnetically coupled state where the moments are randomly oriented. Thus, the electric resistance equivalent body is formed, and the electric resistance increases. Therefore, it comes to improve the effect of the electromagnetic wave absorption because of the increase in the electric resistance. However, the absorption decreases when the electric resistance increases more than a certain level and it comes to show an insulating property as the frequency of the irradiated electromagnetic waves is heightened more.

Herein, the "magneto-resistance" is the phenomenon of change (increment) of the electric resistivity when applying an external magnetic field, and it also depends on the environmental temperature when measuring it.

With respect to the ultrathin carbon fiber which behaves in ferromagnetically and shows negative magneto-resistance, although the detailed mechanisms have been not clear yet, it is considered that the magnetic moments are ferromagnetically coupled without delay, in response to the changes in the magnetic field due to the electromagnetic waves irradiation, in the case of the irradiated electromagnetic waves of a rather low frequency wave range. It is considered, however, by at least the irradiated electromagnetic waves of GHz band range, the parallel couples are disturbed, and the magnetic moments comes to take the antiferromagnetically coupled state where the moments are randomly oriented, and thus, the electric resistance equivalent body is formed, and the electric resistance increases. That is, it has been found that the composite which uses the above mentioned ultrathin carbon fibers which show a negative magneto-resistance as the loss material demonstrates a strong electromagnetic wave absorption capability in GHz band.

Incidentally, when the strength of the external magnetic field is enhanced and the temperature rises, the reluctivity of the ultrathin carbon fiber generally increases, and the magneto-resistance tends to show a positive value. Therefore, in order to satisfy an expected performance as an electromagnetic wave absorber, it is preferable to take negative values in the temperature range of at least not lower than 298K against the external magnetic fields of up to 1 Tesla. When the area where the magneto-resistance becomes negative is laid in a range of less than 1 Tesla, the absorption at GHz band becomes weaker, although it is sure to function as an electromagnetic wave absorber. Moreover, when the area where the magneto-resistance becomes negative is laid only in the temperature range of lower than 298K, the ordinary using temperature of the obtained electromagnetic wave absorber has to be limited to the upper bound temperature of the range in which the negative magneto-resistance is shown, thus the practical utility of the electromagnetic wave absorber becomes low.

Moreover, the defect in the graphite structures in the ultrathin carbon fiber induces scattering of the conduction electron having spin, and disturbs the systematic magneto-resistance effect as mentioned above. For instance, when the signal intensity ratio I_{D}/I_{G} of a peak (G band) at 1580 cm⁻¹ and a peak (D band) at 1360 cm⁻¹, as determined by Raman spectroscopy, is used as an index of this defect, it is preferable that the signal intensity ratio is not more than 0.2, more preferably, not more than 0.1. Ultrathin carbon fiber which has the defects that indicates a value of higher than the above mentioned bound has a fear of deteriorating the electromagnetic wave absorption effect and lowering the absorbable frequency band region.

Incidentally, in the Raman spectroscopy, a large single crystal graphite has only a peak (G band) at 1580 cm⁻¹. When the graphite crystals are small or have any lattice defects, a peak (D band) at 1360 cm-1 can appear. Thus, when the intensity ratio (R=I₁₃₆₀/I₁₅₈₀=I_{D}/I_{G}) of the D band and the G band is below the bound defined above, the graphene sheets have little defect.

When the resistance equivalent body formed by the negative magneto-resistance constructs conductive pathways throughout a macro region, the electromagnetic wave absorption capability increases. In order to construct the conductive pathways with a lesser density of the ultrathin carbon fibers, it is desirable that the diameter and the aspect ratio (length/diameter) of ultrathin carbon fibers are in the range of 15-100nm, and the range of not less than 50, respectively. It is because more ultrathin carbon fibers would be necessitated for constructing the conductive pathways, and a fear that the characteristics originally owned by the matrix, per se, are ruined may arise.

The ultrathin carbon fibers having such characteristics mentioned above can be prepared as follows, for instance.

Briefly, an organic compound, such as a hydrocarbon, is thermally decomposed in CVD process in the presence of ultra fine particles of a transition metal as a catalyst. However, it is preferable that the residence times for ultrathin carbon fiber nucleus, intermediate product, and fiber product in the generation furnace are made to be shortened in order to produce carbon fibers (hereinafter, referred to as "intermediate" or "first intermediate"), and the intermediate thus obtained is then heated at high temperature in order to produce the desirable ultrathin carbon fibers.

### (1) Synthesis Method

Although the intermediate or first intermediate may be synthesized using a hydrocarbon and the CVD process conventionally used in the art, the following modifications of the process are desired:
A) The residence time of the carbon in the generation furnace, which is computed from the mass balance, is adjusted to be below 10 seconds;
B) In order to increase the reaction rate, the temperature in the generation furnace is set to 800-1300 °C;
C) Before adding to the generation furnace, the catalyst and the hydrocarbon raw material are preheated to a temperature of not less than 300 °C so that the hydrocarbon can be delivered in gaseous form to the furnace; and
D) The carbon concentration in the gas in the generation furnace is adjusted so as to be not more than a selected value (e.g. 20 % by volume).

### (2) High temperature heat treatment process

To manufacture the ultrathin carbon fiber used in the present invention efficiently, the intermediate or first intermediate obtained by the above method is subjected to high temperature heat treatment at 2400-3000 °C in an appropriate way. The fibers of the intermediate or first intermediate include a lot of adsorbed hydrocarbons because of the unique process described above. Therefore, in order to have the fibers usable industrially, it is necessary to separate the adsorbed hydrocarbons from the fibers. To separate the unnecessary hydrocarbons, the intermediate may be subjected to heat treatment at a temperature in the range of 800 - 1200 °C in a first heating furnace. However, defects in the graphene sheet may not be repaired to an adequate level in the aforementioned hydrocarbon separation process. Therefore, the resultant product from this process may be further subj ected to another heat treatment in a second heating furnace at a temperature higher than the synthesis temperature. The second heat treatment are performed on the powdered product as-is, without subjecting the powder to any compression process.

For the high temperature heat treatment at 2400 - 3000 °C, any process conventionally used in the art may be used, except that the following modifications are desirable:
A) The fibers obtained from the CVD process mentioned above are subjected to heat treatment at 800 - 1200 °C to separate the hydrocarbon from the fibers; and
B) In the next step, the resultant fibers are subjected to high temperature heat treatment at 2400 - 3000 °C.

In this process, it is possible to add a reducing gas or a small amount of carbon monoxide gas into the inert gas atmosphere to protect the material structure.

As raw material organic compounds, hydrocarbons such as benzene, toluene, and xylene; carbon monoxide (CO); or alcohols such as ethanol may be used. As an atmosphere gas, hydrogen, inert gases such as argon, helium, xenon may be used.

As catalysts, a mixture of transition metal such as iron, cobalt, molybdenum or a transition metal compounds such as ferrocene, metal acetate, and sulfur or a sulfur compound, such as thiophene or ferric sulfide, may be used.

Concretely, in a system where the supply of raw material and the discharge are circulated, a raw material organic compound is heated to a temperature of not less than 300 °C along with an atmosphere gas, with using a transition metal or transition metal compound as a catalyst, in order to gasify them. Then, the gasified mixture is added to the generation furnace and heated therein at a constant temperature in the range of 800 - 1300 °C, preferably, in the range of 1000 - 1300 °C, in order to decompose the raw material hydrocarbon thermally and to synthesize ultrathin carbon fibers. By adding a prescribed amount of sulfur or sulfur compound, the catalyst activity at the thermal decomposition can be controlled, and the ultrathin carbon fibers having less defect can be obtained. The obtained ultrathin carbon fibers (as the intermediate or first intermediate), in its as-is powder state, without subjecting them to compression molding, is subjected to high temperature heat treatment either in one step or two steps. In the one-step operation, the intermediate is conveyed into a heating furnace along with the atmosphere gas, and then heated to a temperature (preferably a constant temperature) in the range of 800-1200 °C to remove unreacted raw material and volatile flux, such as tar, by vaporization. Thereafter, it is heated to a temperature (preferably a constant temperature) in the range of 2400 - 3000 °C to decrease the defects in the fibers and to produce the ultrathin carbon fibers which show the negative magneto-resistance and which will be able to constitute a loss material preferably for the electromagnetic absorption use.

Alternatively, when the high temperature heat treatment is performed in two steps, the first intermediate is conveyed, along with the atmosphere gas, into a first heating furnace that is maintained at a temperature (preferably a constant temperature) in the range of 800 - 1200 °C to produce a ultrathin carbon fiber (hereinafter, referred to as "second intermediate") from which unreacted raw materials and volatile flux such as tar has been removed by vaporization. Next, the second intermediate is conveyed, along with the atmosphere gas, into a second heating furnace that is maintained at a temperature (preferably a constant temperature) in the range of 2400 - 3000 °C to decrease the defects in the fibers and to produce the ultrathin carbon fibers which show the negative magneto-resistance and which will be able to constitute a loss material preferably for the electromagnetic absorption use.

When the above mentioned ultrathin carbon fibers are combined with an organic polymer, an inorganic material, etc. , the ultrathin carbon fibers can construct a network in the matrix of the above mentioned materials, and thus the electromagnetic wave absorber according to the present invention is provided. An excellent electromagnetic wave absorption capability, particularly, that for the electromagnetic waves of GHz band, is provided by using the ultrathin carbon fiber, regardless of the kind of matrix used which involves various materials from the materials of low dielectric constants to the metals.

Although the ratio of the ultrathin carbon fibers to be added to the matrix in order to prepare the electromagnetic wave absorber according to the present invention may be varied by the kind of the matrix used, and by the kind of the applied usage of the electromagnetic wave absorber, it may be about 0.01 % - about 20 % by weight, preferably, not more than 5 % by weight, based on the total weight of the electromagnetic wave absorber. Further, from the viewpoint of not deteriorating the characteristics of the matrix, it is more preferable to be not more than 1 % by weight. Even when the content of the ultrathin carbon fibers as the loss material is extremely low as mentioned above, the electromagnetic wave absorber can exhibit an adequate electromagnetic wave absorption capability because of the easiness of the formation of the network in the matrix and the excellent dispersibility.

Although the organic polymer used as the matrix is not especially limited, for instance, various thermoplastic resins such as polypropylene, polyethylene, polystyrene, polyvinyl chloride, polyacetal, polyethylene terephthalate, polycarbonate, polyvinyl acetate, polyamide, polyamide imide, polyether imide, polyether ether ketone, polyvinyl alcohol, poly phenylene ether, poly (meth) acrylate, and liquid crystal polymer; and various thermosetting resins such as epoxy resin, vinyl ester resin, phenol resin, unsaturated polyester resin, furan resins, imide resin, urethane resin, melamine resin, silicone resin and urea resin; as well as various elastomers such as natural rubber, styrene butadiene rubber (SBR), butadiene rubber (BR), polyisoprene rubber (IR), ethylene-propylene rubber (EPDM), nitrile rubber (NBR), polychloroprene rubber (CR), isobutylene isoprene rubber (IIR),polyurethane rubber,siliconerubber,fluorine rubber, acrylic rubber (ACM), epichlorohydrin rubber, ethylene acrylic rubber, norbornene rubber and thermoplastic elastomer can be enumerated as the organic polymer.

Furthermore, the organic polymer may be in various forms of composition, such as adhesive, fibers, paint, ink, etc.

That is, for example, the matrix may be an adhesive agent such as epoxy type adhesive, acrylic type adhesive, urethane type adhesive, phenol type adhesive, polyester type adhesive, polyvinyl chloride type adhesive, urea type adhesive, melamine type adhesive, olefin type adhesive, acetic acid vinyl type adhesive, hotmelt type adhesive, cyano acrylate type adhesive, rubber type adhesive, cellulose type adhesive, etc.; fibers such as acrylic fibers, acetate fibers, aramid fiber, nylon fibers, novoloid fibers, cellulose fibers, viscose rayon fibers, vinylidene fibers, vinylon fibers, fluorine fibers, polyacetal fibers, polyurethane fibers, polyester fibers, polyethylene fibers, polyvinyl chloride fibers, polypropylene fibers, etc.; or a paint such as phenol resin type, alkyd type, epoxy type, acrylic resin type, unsaturated polyester type, polyurethane type, silicon type, fluorine resin type, synthetic resin emulsion type, etc.

As the inorganicmaterial, for instance, various metals, ceramic materials and inorganic oxide polymers may be enumerated. As preferred concrete examples, metals such as aluminum, magnesium, lead, cupper, tungsten, titanium, niobium, hafnium, vanadium, and alloys thereof and blends thereof; carbon materials such as carbon-carbon composite; glass, glass fiber, flat glass and other forming glass; and silicate ceramics and other heat resisting ceramics, e.g. aluminum oxide, silicon carbide, magnesium oxide, silicone nitride and boron nitride can be enumerated.

Moreover, in the electromagnetic wave absorber according to the present invention, it is possible to include other filling agents in addition to the above mentioned ultrathin carbon fibers in order to modify the electromagnetic wave absorbing material properly. As such a filling agent, for instance, metallic minute particles, silica, calcium carbonate, magnesium carbonate, carbon black, glass fibers, and carbon fibers can be enumerated. These filling agents may be used singly or in any combination of more than two agents. Although the presence or absence of these filling agents varies the mechanical characteristics and the thermal characteristics, the fact is hardly influential in the electromagnetic wave absorption capability.

Preparation of the composite can be performed in accordance with any known method by selecting an optimal method depending on the kind of the matrix used, for instance, in the case of an organic polymer, it may be accomplished by kneading under melted condition, dispersion into a thermosetting resin composition, dispersion into a lacquer, etc, and in the case of an inorganic material, it may be accomplished by particle sintering, sol - gel method, dispersion in a molten metal, etc. Even in any cases, since the ultrathin carbon fiber can be dispersed satisfactorily in the matrix and can form a network, the product can exhibit an excellent electromagnetic wave absorption capability.

The thus obtained electromagnetic wave absorption material according to the present invention can remarkably reduce the influence of the electromagnetic waves, when it is processed into a film, a seat or a casing product for any apparatus and it is used at an appropriate place.

### EXAMPLES

Hereinafter, this invention will be illustrated more concretely by practical examples. However, it is to be understood that the examples shown below are exemplified only for the sake of making the description and understanding of the present invention easy, and thus, the present invention is not limited thereto.
Incidentally, the respective physical properties described in Examples and Controls disclosed later were determined by the following conditions.

### <Raman spectroscopic analysis>

Raman spectroscopic analysis was performed with LabRam 800^{™}, which is manufactured by HORIBA JOBIN YVON, S.A.S. The measurements were performed with 514 nm light from an argon laser.

### <Magneto-resistance>

On a resin sheet, a mixture of carbon nanotubes (2% or 5%) and an adhesive was coated as a line. The thickness, width and length were about 1 mm, 1 mm, and 50 mm, respectively. Next, the sample was put into the magnetic field measuring equipment. Magnetic flux was applied in various directions, and the resistances of the sample at 77K and 298K were measured.

### <Electromagnetic wave absorption capability>

This capability was determined by using an instrument construction which equipped with a R/S SMR20 type signal generator, an Advantest TR-17302 type chamber, a HP8449B type preamplifier, and an Agilent E7405 type spectrum analyzer, and in accordance with the ADVANTEST method.

### Referential Example 1: Synthesis of ultrathin carbon fiber

Using the CVD process, ultrathin carbon fibers were synthesized from toluene as a raw material.

The synthesis was carried out in the presence of a mixture of ferrocene and thiophene as the catalyst, and under a reducing atmosphere of hydrogen gas. Toluene and the catalyst were heated to 375 °C along with the hydrogen gas, and then they were supplied to a generation furnace to react at 1200 °C for a residence time of 8 seconds. The atmosphere gas was separated by a separator in order to use the atmosphere gas repeatedly. The hydrocarbon concentration in the supplied gas was 9 % by volume. The obtained ultrathin carbon fibers were heated to 1200 °C, and kept at that temperature for 30 minutes in order to effectuate the hydrocarbon separation. Thereafter, the fibers were subjected to high temperature heat treatment at 2500 °C.

It was found that the diameters, aspect ratios, and I_{D}/I_{G} ratio which was measured by Raman spectroscopy, of the obtained fibers were 10 - 60 nm, 250 - 2000, and 0.05, respectively.

As shown in Table 1 and Fig. 3, with respect to the magneto-resistance of these fibers, it indicated negative values as the magnetic flux density rose. The resistance ratio of 77K and 298K was positive.

**[Table 1]**

| Sample | Ultrathin carbon fiber 2% | Ultrathin carbon fiber 5% |
|---|---|---|
| (Δρ/ρ)ₘₐₓ, at 77 K, 1 T | -1.08 | -1.00 |
| Resistance ratio ρ_{298K}/ρ_{77K} | 0.82 | 0.79 |

### Referential Example 2

Carbon nanotubes were synthesized by the same procedure with Referential Example 1 except that the residence time at the reaction was set to 12 seconds. It was found that the diameters, aspect ratios, and I_{D}/I_{G} ratio which was measured by Raman spectroscopy, of the obtained fibers after the heat treatment were 40 - 90 nm, 50 - 300, and 0.16, respectively. The magneto-resistance of these fibers indicated negative values as the magnetic flux density rose, and the resistance ratio of 77K and 298K was positive.

### Example 1

A homogenous composition was prepared by blending 0.2 % by weight of the ultrathin carbon fibers obtained in Referential Example 1, with an epoxy resin (ADEKA RESIN^{™}, manufactured by Asahi Denka Co., Ltd.) and a hardener (ADEKA HARDENER^{™}, manufactured by Asahi Denka Co., Ltd.). Then, the obtained homogenous composition was hardened under a pressurized condition and with spending 4 hours from the room temperature to 120 °C, in order to obtain a plate-shaped composite having 2 mm in thickness. Since this composite demonstrates the electromagnetic wave attenuation shown in Table 2, it can be used preferably as an electromagnetic wave absorption material.

### Example 2

20 % by weight of the ultrathin carbon fibers obtained by Referential Example 2 were mixed uniformly with polycarbonate which was melted at 260 °C in a kneader equipped with biaxial screws. The obtained composite was then molded into a plate of 2 mm in thickness by injection molding at 260 °C. Since this molded article demonstrates the electromagnetic wave attenuation shown in Table 2, it can be used preferably as an electromagnetic wave absorption material.

### Example 3

A mixture of tetraethoxy silane 100g, ethanol 50 ml, water 50 ml, the ultrathin carbon fibers obtained in Referential Example 1 0. 58g, and 0.05N hydrochloric acid 1ml was stirred for 12 hours at 40 °C. The obtained viscous liquid were spread in a glass flame and dried at 60 °C. Then, the obtained solid content was heated at 550 °C for 12 hours under a pressurized condition in order to obtain a glass-like plate. Since this glass-like plate demonstrates the electromagnetic wave attenuation shown in Table 2, it can be used preferably as an electromagnetic wave absorption material.

### Example 4

A homogenous composition was prepared by adding 1 % by weight of the ultrathin carbon fibers obtained in Referential Example 1, and 5 % by weight of nickel particles of which mean diameter was 1.5 µm, into an epoxy resin (ADEKA RESIN^{™}, manufactured by Asahi Denka Co., Ltd.) and a hardener (ADEKA HARDENER^{™}, manufactured by Asahi Denka Co., Ltd.). Then, the obtained homogenous composition was hardened under a pressurized condition and with spending 4 hours from the room temperature to 120 °C, in order to obtain a plate-shaped composite having 2 mm in thickness. Since this composite demonstrates the electromagnetic wave attenuation shown in Table 2, it can be used preferably as an electromagnetic wave absorption material.

### Examples 5-6

Composites were prepared by using the ultrathin carbon fibers obtained in Referential Example 2, and melting or sintering the respective compositions shown in Table2. Since these composites demonstrate the electromagnetic wave attenuations shown in Table 2, they can be used preferably as electromagnetic wave absorption materials.

**[Table 2]**

| Ex. | Ultrathin carbon fiber | | | | Matrix | Electromagnetic wave absorption capability | |
|---|---|---|---|---|---|---|---|
| | Diameter (nm) | Aspect ratio | I_{D}/I_{G} | Content (%) | | Frequency (GHz) | Attenuation (dB) |
| 1 | 10-60 | 250-200 | 0.05 | 0.2 | Epoxy resin | 2.0 | 31 |
| | | | | | | 5.8 | 19 |
| | | | | | | 7.5 | 15 |
| 2 | 40-90 | 50-300 | 0.16 | 20 | Poly | 2.0 | 49 |
| | | | | | carbonate | 6.5 | 23 |
| | | | | | | 7.5 | 32 |
| | | | | | | 9.8 | 23 |
| 3 | 10-60 | 250-2000 | 0.05 | 2 | Glass | 1.8 | 26 |
| | | | | | | 5.8 | 28 |
| 4 | 10-60 | 250-2000 | 0.05 | 1 | Epoxy resin | 2.0 | 21 |
| | | | | | | 5.8 | 19 |
| 5 | 40-90 | 50-300 | 0.16 | 5 | Aluminum | 3.2 | 37 |
| | | | | | | 6.8 | 32 |
| | | | | | | 8.4 | 23 |
| | | | | | | 9.8 | 28 |
| 6 | 40-90 | 50-300 | 0.16 | 20 | Boron Nitride | 4.6 | 37 |
| | | | | | | 6.4 | 24 |

## Claims

1. Electromagnetic wave absorber which includes ultrathin carbon fibers which show a negative magneto-resistance, at a ratio of 0.01 - 20 % by weight based on the total weight, into a matrix.

2. The electromagnetic wave absorber according to Claim 1, wherein the magneto-resistance shows negative values in the temperature range of at least not lower than 298K against external magnetic fields of up to 1 Tesla.

3. The electromagnetic wave absorber according to Claim 1 or 2, wherein the matrix comprises an organic polymer.

4. The electromagnetic wave absorber according to Claim 1 or 2, wherein the matrix comprises an inorganic material.

5. The electromagnetic wave absorber according to one of Claims 1-4, wherein a filling agent selected from the group consisting of metallic particles, silica, calcium carbonate, magnesium carbonate, carbon blacks, carbon fibers, glass fibers, and blends of two or more of these materials is further added therein.
